# EUROPÄISCHE PATENTSCHRIFT

(11) **EP 0 642 600 B1**
(45) Veröffentlichungstag und Bekanntmachung des Hinweises auf die Patenterteilung: **27.11.1996**
(21) Anmeldenummer: 94910335.2
(22) Anmeldetag: 17.03.1994
(51) Int. Cl.: C23C 16/50, C23C 16/44, C23C 16/54, H01J 37/32

(54) **VORRICHTUNG ZUR HERSTELLUNG EINER PLASMAPOLYMERSCHUTZSCHICHT AUF WERKSTÜCKEN, INSBESONDERE SCHEINWERFERREFLEKTOREN**
DEVICE FOR PRODUCING A PLASMA POLYMER PROTECTION LAYER ON WORKPIECES, IN PARTICULAR HEADLAMP REFLECTORS
DISPOSITIF PERMETTANT LA PRODUCTION D'UNE COUCHE DE PROTECTION POLYMERE AU PLASMA SUR DES PIECES, NOTAMMENT DES REFLECTEURS DE PHARE

(30) Priorität: 30.03.1993 DE 4310258
(43) Veröffentlichungstag der Anmeldung: 15.03.1995
(73) Patentinhaber: ROBERT BOSCH GMBH, 70442 Stuttgart (DE)
(72) Erfinder: SCHNEIDER, Guenter, D-74354 Besigheim (DE); BENZ, Gerhard, D-71032 Böblingen (DE); HAHN, Juergen, D-73265 Dettingen (DE)
(86) Internationale Anmeldenummer: DE9400286
(87) Internationale Veröffentlichungsnummer: WO9423088

(56) Entgegenhaltungen:
- EP-A- 0 284 436
- EP-A- 0 430 079
- WO-A-91/12353
- PATENT ABSTRACTS OF JAPAN vol. 13, no. 171 (C-588) 12. April 1989 & JP,A,64 000 271 (CANON) 5. Januar 1989

## Beschreibung

### STAND DER TECHNIK

Die Erfindung betrifft eine Vorrichtung zur Herstellung einer Plasmapolymerschutzschicht auf Werkstücken, insbesondere Scheinwerferreflektoren, nach der Gattung des Hauptanspruchs.

Um die im allgemeinen aus hochglänzendem Aluminium bestehende Reflexionsschicht auf Scheinwerferreflektoren gegen Korrosion zu schützen, muß eine Korrosionsschutzschicht über der Aluminiumschicht aufgebracht werden. Zur Herstellung einer solchen Korrosionsschutzschicht für Scheinwerferreflektoren hat sich allgemein das Verfahren der Plasmapolymerisation durchgesetzt. Eine frühe, aus der DE-PS 26 25 448 bekannte Verfahrensvariante beruht auf einer unselbständigen Glimmentladung zur Erzeugung des für die Aktivierung eines zu polymerisierenden Monomers notwendigen Plasmas. Ein neueres, aus der DE-OS 40 03 904 bekanntes Verfahren zur Herstellung einer solchen Schutzschicht beruht auf der Plasmaerzeugung im Mikrowellenbereich durch Elektronen-Zyklotron-Resonanz (ECR). Bei Erfüllung der ECR-Bedingung wird im Magnetfeld einer aus Permanentmagneten bestehenden Magnetbank ein Plasma gezündet. Wird ein polymerisierbares Monomer, wie Hexamethyldisiloxan, in die Beschichtungskammer eingeleitet, so kann damit eine Glimmpolymerschutzschicht abgeschieden werden. Dies ist in der genannten Druckschrift näher beschrieben.

Beide Verfahren werden heutzutage in einem sogenannten Batch-Prozeß technisch angewandt, das heißt, der Fertigungsfluß bei der Herstellung eines Scheinwerfers wird unterbrochen, und einige hundert manuell chargierte Reflektoren werden in einer Beschichtungskammer mit der Korrosionsschutzschicht versehen und danach wieder manuell dem Fertigungsfluß zugeführt. Ein Problem besteht nämlich bei beiden Verfahren darin, daß die Beschichtungsquelle nicht vollkommen wartungsfrei ist: Bei der unselbständigen Glimmentladung gemäß dem früheren Verfahren müssen die verwendeten Wolfram-Glüh-Emitter nach wenigen Chargen ersetzt werden. Bei der neueren ECR-Technik werden die verfahrensbedingt erforderlichen Magnete ebenfalls beschichtet und müssen daher, um eine unkontrollierte Flitterbildung zu vermeiden, von Zeit zu Zeit abgebürstet werden. Dies bedeutet jedoch, daß diese Verfahren nicht ohne weiteres in einen in-line-Prozeß eingebaut werden können. Die Beschichtungskammer muß immer unter Vakuum bleiben, und die Reflektoren werden über Schleusen ein- und ausgeschleust. Ein Wartungs-schritt, beispielsweise zur Reinigung der Magnete, würde eine Belüftung der Beschichtungskammer erforderlich machen und daher einen Fertigungsstopp bedeuten.

### VORTEILE DER ERFINDUNG

Die erfindungsgemäße Vorrichtung mit den kennzeichnenden Merkmalen des Hauptanspruchs hat demgegenüber den Vorteil daß das bekannte ECR-Beschichtungsverfahren im in-line-Prozeß eingesetzt werden kann, ohne daß Fertigungsstopps auf Grund von Reinigungsarbeiten erforderlich wären. Dadurch, daß die Magnete an den Werkstückträgern angeordnet sind, können diese durch die evakuierte Beschichtungskammer mit Hilfe von Vakuumschleusen hindurch- und außerhalb dieser Kammer wieder zurückgeführt werden. In der Rückführungsstrecke außerhalb der Beschichtungskammer kann dann ohne Schwierigkeiten eine Reinigungskammer angeordnet werden, um insbesondere die Magnete vom Beschichtungsmaterial zu befreien. Der Beschichtungsprozeß kann daher kontinuierlich ablaufen, wobei auch die Reinigung der Werkstückträger und damit der Magnete kontinuierlich erfolgt.

Durch die in den Unteransprüchen aufgeführten Maßnahmen sind vorteilhafte Weiterbildungen und Verbesserungen der im Hauptanspruch angegebenen Vorrichtung möglich.

Die Transporteinrichtung weist zweckmäßigerweise eine dem Fertigungstakt für die Werkstücke entsprechende Vorlaufgeschwindigkeit auf, so daß diese Vorrichtung problemlos in eine vorhandene Fertigungsstraße eingebaut werden kann.

Die Plasmapolymer-Beschichtungskammer wird zwischen Vakuumeinschleus- und -ausschleusvorrichtungen angeordnet. Dabei kann der Beschichtungskammer vorzugsweise eine Metallisierungskammer und dieser eine Vorglimmkammer vorgeschaltet sein, so daß auch der reflektierende Metallauftrag auf den Reflektor im gleichen Durchgang kurz vor Aufbringen der Korrosionsschicht erzeugt werden kann.

Um eine hohe Abscheiderate und eine gute Dickenkonstanz für die Schutzschicht auf den optisch wirksamen Flächen zu erzeugen, greifen die Permanentmagnete an den Werkstückträgern in die dort angeordneten Scheinwerferreflektoren hinein, vorzugsweise durch die Lampenöffnungen. Eine zweckmäßige konstruktive Ausgestaltung besteht dabei darin, daß die Scheinwerferreflektoren mit nach oben gerichteter Reflektoröffnung in entsprechend ausgebildete Ausnehmungen des Werkstückträgers eingesetzt sind, wobei jeweils wenigstens einer der Permanentmagnete von unten her durch die Lampenöffnung ins Innere des Scheinwerferreflektors eingreift. Hierzu ist dieser Permanentmagnet in vorteilhafter Weise an einem Haltestab angeordnet. Hierbei ist gewährleistet, daß der der Schutzbeschichtung vorgeschaltete metallische Beschichtungsprozeß für die reflektierende Schicht nicht behindert wird, das heißt, daß es zu keiner Abschattung einzelner Zonen auf dem Reflektor kommt.

Durch weitere Magnete an der Peripherie des Reflektors kann die Schichtdickenverteilung gezielt beeinflußt werden, z.B. kann eine Schichtdickenanhebung im Randbereich bei Planflächen erreicht werden.

Als Reinigungseinrichtung für die Reinigungsstation eignen sich insbesondere rotierende Bürsten und/oder eine Druckluftreingigungseinrichtung.

### ZEICHNUNG

Ein Ausführungsbeispiel der Erfindung ist in der Zeichnung dargestellt und in der nachfolgenden Beschreibung näher erläutert. Es zeigen:
- Fig. 1: eine schematische Darstellung der Beschichtungs- und Reinigungsvorrichtung und
- Fig. 2: einen in einen Werkstücksträger eingesetzten Scheinwerferreflektor.

### BESCHREIBUNG DES AUSFÜHRUNGSBEISPIELS

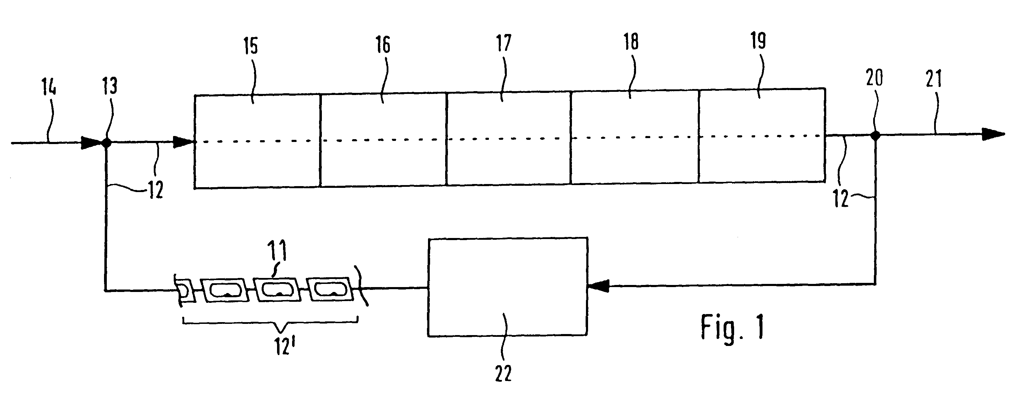

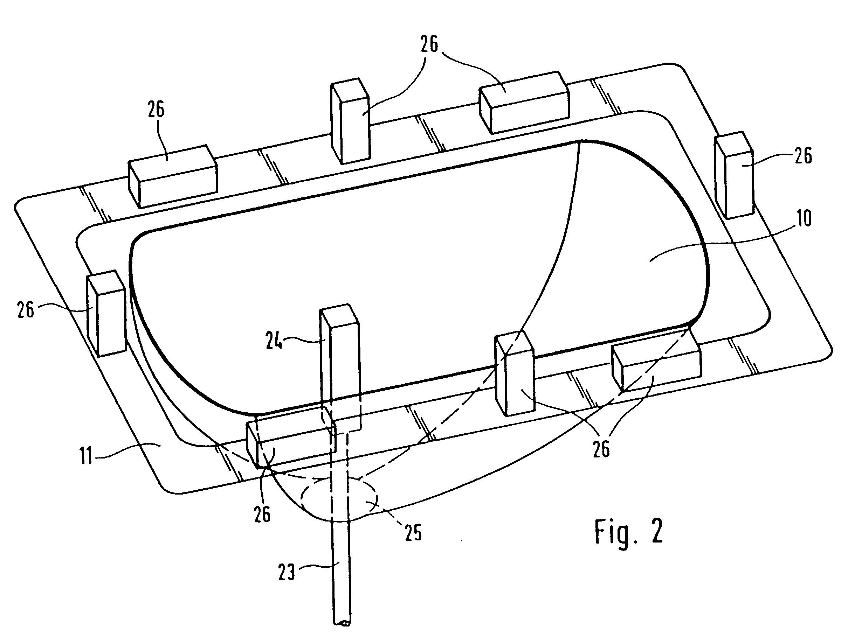

Gemäß dem in Fig. 1 schematisch dargestellten Ausführungsbeispiel werden Scheinwerferreflektoren 10 zur Beschichtung auf Werkstückträgern 11 angeordnet, die sich entlang einer geschlossenen Bahn 12 bewegen. In einem Ausschnittsbereich 12' dieser Bahn 12 sind derartig beschickte Werkstücktträger 11 ebenfalls schematisch dargestellt. In einer praktischen Anordnung können selbstverständlich auch mehrere Reihen neben- und/oder übereinander angegeordnet sein. Eine detailliertere Darstellung derartiger Werkstückträger 11 zeigt Fig. 2.

An einer übergabestation 13 werden entlang einer Transportstrecke 14 ankommende Scheinwerferreflektoren 10 auf die Werkstückträger 11 aufgebracht bzw. aufgelegt. Die Transportstrecke 14 führt beispielsweise in einem Kunststoffspritzprozeß hergestellte Scheinwerferrreflektoren der Bahn 12 zu.

Zunächst gelangen die mit Scheiwerferrreflektoren 10 versehenen Werksstückträger 11 in eine Vakuumeinschleuskammer 15, dann in eine Vorglimmkammer 16, die in Einzelfällen auch entfallen kann, dann in eine Metallisierungskammer 17, dann in eine Schutzbeschichtungskammer 18, aus der sie über eine Vakuumausschleuskammer 19 wieder herausgeführt werden. An einer übergabestation 20 werden dann die beschichteten Scheinwerferreflektoren 10 wieder einer Transportstrecke 21 zur weiteren Verarbeitung bzw. Verpackung übergeben.

In der Metallisierungskammer wird die reflektierende Metallschicht beispielsweise durch Magnetron-Sputtern aufgebracht, die für andere, in Durchlaufanlagen hergestellte Schichten zum Stand der Technik gehört. Die Sputter-Technik bietet eine für den gewünschten Einzelfall ausreichend hohe Beschichtungsrate. Für Hauptscheinwerfer mit einem möglichst hohen Reflexionsvermögen von über 80 % wird als Metallschicht Aluminium aufgesputttert, welches zusätzlich korrosionsgeschützt werden muß. Bei Leuchten oder Elementen mit geringeren Anforderungen an das Reflexionsvermögen (z.B. 60 - 70 %) bietet die Magnetron-Sputter-Technik zusätzlich die Möglichkeit, korrosionsbeständigen Edelstahl od. ähnl. zur Metallisierung einzusetzen.

Die Schutzschicht in der Schutzbeschichtungskammer 18 wird nach dem in der DE-OS 40 03 904 beschriebenen ECR-Verfahren hergestellt. Dabei wird Mikrowellenenergie in bekannter Weise durch ein nicht dargestelltes Fenster in der Schutzbeschichtungskammer 18 eingekoppelt und durch eine sich an das Fenster anschließende, ebenfalls nicht dargestellte Mikrowellenantenne in das Innere des Rezipienten eingespeist. Der Druck des in die Schutzbeschichtungskammer 18 eingeleiteten polymerisierbaren Monomers wird dabei so eingestellt, daß nach dem Paschen-Gesetz noch kein Plasmazünden erfolgt. Es ist lediglich "latent" Mikrowellenenergie im Inneren der Prozeßkammer vorhanden.

In bekannter Weise werden nun die zur Erfüllung der Resonanzbedingung bei der ECR-Technik zusätzlich benötigten Magnete bzw. Permanentmagnete verwendet. Die Anordnung der Magnete ist in Fig. 2 dargestellt und wird später noch näher erläutert. Auf Grund der Druckbedingungen brennt das Plasma nur in der Nähe der Magnete, und es wird eine Glimmpolymerschutzschicht auf den Scheinwerferreflektoren 10 abgeschieden.

Die aus der Vakuumausschleuskammer 19 austretenden Werkstückträger werden nach der Abnahme der beschichteten Scheinwerferreflektoren 10 in einer Rücklaufstrecke einer Reinigungsstation 22 zugeführt, die als automatische Reinigungsstation ausgebildet ist. Dort werden die stark beschichteten Magnete von störendem Flittern befreit, beispielsweise durch rotierende Bürsten. Die gereinigten Werkstückträger mit den gereinigten Magneten werden dann wieder der Ober-gabestation 13 zugeführt, wo sie erneut mit Scheinwerfer-reflektoren 10 beschickt werden.

In Fig. 2 ist ein Ausführungsbeispie für eine Magnetanordnung an einem Werkstückträger 11 dargestellt. Dieser Werkstückträger 11 weist eine Ausnehmung auf, in die ein Scheinwerferreflektor 10 von oben her eingesetzt wird. Dabei greift von unten her ein an einem vertikalen Stab 23 befestigter Permanentmagnet 24 durch die Lampenöffnung 25 des Scheinwerferreflektors 10 in dessen Innenraum ein. Dieser Magnet muß so dimensioniert sein, daß er in der Nähe seiner Oberfläche die bei der üblichen Mikrowellenfrequenz von 2,45 GHz zur Erzeugung eines ECR-Plasmas notwendige magnetische Flußdichte von mindestens 87,5 mT besitzt. Dadurch kann im Inneren des Scheinwerferreflektors 10 ein intensives Plasma erzeugt werden, das zu einer sehr gleichmäßigen Beschichtung bei ausreichend hoher Rate führt. Entlang der Reflektorperipherie sind zusätzliche Permanentmagnete 26 am Werkstückträger 11 befestigt. Hierdurch kann die Plasmaentladung erweitert werden und somit die Abscheiderate der Schutzschicht in Randzonen individuell angehoben werden. Insbesondere bei Reflektoren mit ausgedehnten Planflächen werden derartige zusätzliche Permanentmagnete 26 eingesetzt. Bei einfacheren Ausführungen und kleineren Reflektoren können diese zusätzlichen Permanentmagnete 26 auch entfallen. Wichtig ist dabei, daß die Anordnung der Magnete den zuvor ablaufenden metallischen Beschichtungsprozeß unter einer Sputter-Kathode nicht behindern. Dies bedeutet, daß es zu keiner Abschattung einzelner Zonen auf dem Reflektor kommen darf. Es sei noch darauf hingewiesen, daß der Stab 23 selbstverständlich ebenfalls in nicht dargestellter Weise am nur schematisch dargestellten Werkstückträger 11 befestigt ist.

Das dargestellte Ausführungsbeispiel trägt als Scheinwerferreflektor 10 einen tiefgeformten Kunststoffreflektor mit Planfläche. Als Permanentmagnete 24,26 können CoSm-Permanentmagnete verwendet werden. Als polymerisierbares Monomer in der Schutzbeschichtungskammer 18 eignet sich Hexamethyldisiloxan, bei einem Druck von 0,8 - 5 x 10⁻³ mbar.

Die beschriebene Vorrichtung eignet sich selbstverständlich nicht nur für Scheinwerferreflektoren, vielmehr können beliebige Gegenstände durch diese Vorrichtung mit einer Plasmapolymerschutzschicht versehen werden.

## Patentansprüche

1. Vorrichtung zur Herstellung einer Plasmapolymerschutzschicht auf Werkstücken, insbesondere Scheinwerferreflektoren, mit einer Beschichtungskammer, in die ein polymerisierbares Monomer einleitbar ist, und mit Mittelnzum Einkoppeln von Mikrowellen in die Beschichtungskammer, wobei die Mikrowellen im Bereich des Magnetfeldes von Permanentmagneten ein Plasma zur Abscheidung der Polymerschutzschicht auf den an Werkstückträgern gehaltenen Werkstücken erzeugen, dadurch gekennzeichnet, daß die Permanentmagnete (24,26) an den Werkstückträgern (11) angeordnet sind, und daß eine die Werkstückträger (11) durch die Beschichtungskammer (18) hindurchführende Transporteinrichtung (12) vorgesehen ist, die eine eine Reinigungsstation (22) aufweisende Rückführstrecke für die Werkstückträger (11) außerhalb der Beschichtungskammer (18) zur Rückführung der Werkstückträger (11) vom Ausgang zum Eingang der Beschichtungskammer (18) besitzt.

2. Vorrichtung nach Anspruch 1, dadurch gekennzeichnet, daß die Transporteinrichtung (12) eine dem Fertigungstakt für die Werkstücke (10) entsprechende Vorlaufgeschwindigkeit aufweist.

3. Vorrichtung nach Anspruch 1 oder 2, dadurch gekennzeichnet, daß die Plasmapolymer-Beschichtungskammer (18) zwischen Vakuumeinschleus- und -ausschleusvorrichtungen angeordnet ist.

4. Vorrichtung nach einem der vorhergehenden Ansprüche, dadurch gekennzeichnet, daß der Beschichtungskammer (18) eine Metallisierungskammer (17) vorgeschaltet ist.

5. Vorrichtung nach Anspruch 4, dadurch gekennzeichnet, daß der Metallisierungskammer (17) eine Vorglimmkammer (16) vorgeschaltet ist.

6. Vorrichtung zur Herstellung einer Plasmapolymerschutzschicht auf Scheinwerferreflektoren nach einem der vorhergehenden Ansprüche, dadurch gekennzeichnet, daß im Gebrauch die Permanentmagnete (24) an den Werkstückträgern (11) in die dort angeordneten Scheinwerferreflektoren (10) eingreifen.

7. Vorrichtung nach Anspruch 6, dadurch gekennzeichnet, daß die Permamentmagnete (24) durch die Lampenöffnungen (25) der Scheinwerferreflektoren (10) in diese eingreifen.

8. Vorrichtung nach Anspruch 7, dadurch gekennzeichnet, daß die Scheinwerferreflektoren (10) mit nach oben gerichteter Reflektoröffnung in entsprechend ausgebildete Ausnehmungen der Werkstückträger (11) einsetzbar sind, wobei jeweils wenigstens einer der Permanentmagnete (24) von unten her durch die Lampenöffnung (25) ins Innere des Scheinwerferreflektors (10) eingreift.

9. Vorrichtung nach einem der Ansprüche 6 bis 8, dadurch gekennzeichnet, daß der ins Innere des Scheinwerferreflektors (10) eingreifende Permanentmagnet (24) an einem Haltestab (23) angeordnet ist.

10. Vorrichtung nach einem der Ansprüche 6 bis 9, dadurch gekennzeichnet, daß an der Scheinwerferreflektor-Peripherie weitere Permanentmagnete (26) angeordnet sind.

11. Vorrichtung nach einem der vorhergehenden Ansprüche, dadurch gekennzeichnet, daß die Reinigungsstation (12) wenigstens zur Reinigung der Permanentmagnete (24,26) rotierende Bürsten und/oder eine Luftreinigungseinrichtung aufweist.

## Claims

1. Apparatus for producing a plasma polymer protective layer on workpieces, in particular headlamp reflectors, having a coating chamber into which a polymerizable monomer can be introduced and having means for injecting microwaves into the coating chamber, with the microwaves producing, in the region of the magnetic field of permanent magnets, a plasma for depositing the polymer protective layer on the workpieces held on workpiece carriers, characterized in that the permanent magnets (24, 26) are arranged on the workpiece carriers (11), and in that there is provided a transport device (12) which conveys the workpiece carriers (11) through the coating chamber (18), which transport device possesses a return line, having a cleaning station (22), for the workpiece carriers (11) outside the coating chamber (18) for returning the workpiece carriers (11) from the exit to the entrance of the coating chamber (18).

2. Apparatus according to Claim 1, characterized in that the transport device (12) has a feed velocity corresponding to the production rhythm for the workpieces (10).

3. Apparatus according to Claim 1 or 2, characterized in that the plasma polymer coating chamber (18) is arranged between vacuum inlet and outlet locks.

4. Apparatus according to any one of the preceding claims, characterized in that the coating chamber (18) is preceded by a metallization chamber (17).

5. Apparatus according to Claim 4, characterized in that the metallization chamber (17) is preceded by a preglow chamber (16).

6. Apparatus for producing a plasma polymer protective layer on headlamp reflectors according to any one of the preceding claims, characterized in that during use the permanent magnets (24) on the workpiece carriers (11) reach into the headlamp reflectors (10) arranged thereon.

7. Apparatus according to Claim 6, characterized in that the permanent magnets (24) reach through the lamp openings (25) of the headlamp reflectors (10) into the latter.

8. Apparatus according to Claim 7, characterized in that the headlamp reflectors (10) can be set into correspondingly configured recesses of the workpiece carriers (11) with the reflector opening facing upwards, with in each case at least one of the permanent magnets (24) reaching from below through the lamp opening (25) into the interior of the headlamp reflector (10).

9. Apparatus according to any one of Claims 6 to 8, characterized in that the permanent magnet (24) reaching into the interior of the headlamp reflector (10) is fitted to a holding rod (23).

10. Apparatus according to any one of Claims 6 to 9, characterized in that further permanent magnets (26) are arranged on the periphery of the headlamp reflector.

11. Apparatus according to any one of the preceding claims, characterized in that the cleaning station (12), at least for cleaning the permanent magnets (24, 26), has rotating brushes and/or an air cleaning device.

## Revendications

1. Dispositif pour réaliser une couche protectrice de polymère au plasma sur des pièces notamment des réflecteurs de projecteur, comprenant une chambre d'enduction dans laquelle on introduit un monomère susceptible de polymériser et des moyens pour injecter des micro-ondes dans la chambre d'enduction, les micro-ondes générant au niveau du champ magnétique des aimants permanents un plasma pour déposer la couche protectrice de polymère sur les pièces tenues par les supports de pièce,
caractérisé en ce que
les aimants permanents (24, 26) sont prévus sur les supports de pièce (11) pour être conduits par une installation de transport (12) à travers la chambre d'enduction (18), cette installation de transport comprenant un chemin de retour équipé d'un poste de nettoyage (22) pour les supports de pièce (11) à l'extérieur de la chambre d'enduction (18), pour reconduire les supports de pièce (11) de la sortie vers l'entrée de la chambre d'enduction (18).

2. Dispositif selon la revendication 1,
caractérisé en ce que
l'installation de transport (12) travaille à une vitesse de défilement correspondant à la cadence de fabrication des pièces (10).

3. Dispositif selon la revendication 1 ou 2,
caractérisé en ce que
la chambre d'enduction de polymère au plasma (18) est prévue contre un dispositif à sas d'entrée de vide et un dispositif à sas de sortie.

4. Dispositif selon l'une des revendications précédentes,
caractérisé en ce que
la chambre d'enduction (18) est précédée par une chambre de métallisation (17).

5. Dispositif selon la revendication 4,
caractérisé en ce que
la chambre de métallisation (17) est précédée par une chambre à décharges (16).

6. Dispositif pour la fabrication d'une couche protectrice de polymère au plasma sur des réflecteurs de projecteur selon l'une quelconque des revendications précédentes,
caractérisé en ce que
en utilisant des aimants permanents (24) sur les supports de pièce (11), les aimants viennent à l'intérieur des réflecteurs de projecteur (10) placés sur les supports de pièce.

7. Dispositif selon la revendication 6,
caractérisé en ce que
les aimants permanents (24) arrivent à travers les orifices de passage d'ampoule (25) dans les réflecteurs de projecteur (10).

8. Dispositif selon la revendication 7,
caractérisé en ce que
les réflecteurs de projecteur (10) sont placés dans des découpes de forme correspondante des supports de pièce (11), avec les ouvertures de réflecteur tournées vers le haut et chaque fois au moins l'un des aimants permanents (24) pénètre par en dessous à travers l'ouverture de passage d'ampoule (25) à l'intérieur du réflecteur de projecteur (10).

9. Dispositif selon l'une des revendications 6 à 8,
caractérisé en ce que
l'aimant permanent (24) qui vient à l'intérieur du réflecteur de projecteur (10) est monté sur une tige de support (23).

10. Dispositif selon l'une des revendications 6 à 9,
caractérisé en ce que
à la périphérie des réflecteurs de projecteur sont disposés d'autres aimants permanents (26).

11. Dispositif selon l'une des revendications précédentes,
caractérisé en ce que
le poste de nettoyage (12) comporte des brosses tournantes et/ou une installation de nettoyage au moins pour nettoyer les aimants permanents (24, 26).
